Europäisches Patentamt

European Patent Office

Office européen des brevets

(19)

(11) **EP 1 324 061 A2**

(12) **DEMANDE DE BREVET EUROPEEN**

(43) Date de publication:
02.07.2003 Bulletin 2003/27

(51) Int Cl.⁷: **G01R 31/3185**

(21) Numéro de dépôt: 02080373.0

(22) Date de dépôt: 19.12.2002

(84) Etats contractants désignés:
**AT BE BG CH CY CZ DE DK EE ES FI FR GB GR IE IT LI LU MC NL PT SE SI SK TR**
Etats d'extension désignés:
**AL LT LV MK RO**

(30) Priorité: **28.12.2001 FR 0116996**

(71) Demandeur: **Koninklijke Philips Electronics N.V.**
**5621 BA Eindhoven (NL)**

(72) Inventeurs:
• **Souef, Laurent**
**75008 Paris (FR)**

• **Solari, Emmanuel**
**75008 Paris (FR)**
• **Rogge, Soenke**
**75008 Paris (FR)**
• **Kytzia, Rainer**
**75008 Paris (FR)**
• **Wittke, Michael**
**75008 Paris (FR)**

(74) Mandataire: **Lottin, Claudine**
**Société Civile S.P.I.D.**
**156, Boulevard Haussmann**
**75008 Paris (FR)**

(54) **Procédé de test d'un circuit integré par simulation**

(57)     La présente invention concerne un procédé de test de circuit intégré, ledit procédé utilisant au moins un vecteur de test comportant des valeurs sérialisées d'entrée (SHIFT_IN) et de sortie. Il se caractérise en ce qu'il comporte les étapes suivantes :

- Positionner le circuit en mode de sérialisation au début d'un cycle d'horloge (CLK),
- Positionner en parallèle des valeurs sérialisées d'entrée (SHIFT_IN) du vecteur de test (V) sur les sélecteurs (S),

- Charger en parallèle lesdites valeurs sérialisées d'entrée (SHIFT_IN) dans lesdites bascules simples (FF) associées audits sélecteurs (S),
- Positionner le circuit en mode normal,
- Capturer des valeurs sérialisées résultat (SHIFT_RES) dans les bascules (FF),
- Récupérer en parallèle lesdites valeurs sérialisées résultat (SHIFT_RES) dans lesdites bascules (FF) et les comparer aux valeurs sérialisées de sortie du vecteur de test (V).

FIG.1

## Description

La présente invention concerne un procédé de test de circuit intégré destiné à fonctionner selon un mode normal et un mode de sérialisation, ledit circuit comprenant une horloge, des bascules simples et des sélecteurs associés, ledit procédé utilisant au moins un vecteur de test comportant des valeurs sérialisées d'entrée et de sortie.

Elle trouve une application particulière lors de la conception d'un circuit intégré.

Pour tester des circuits intégrés, différentes techniques sont utilisées telles que les techniques dites de "scan test" qui permettent d'aborder le circuit sous forme de blocs combinatoires ou logique combinatoire. Dans ces techniques, le circuit est conçu de manière fonctionner selon deux cycles, un cycle fonctionnel correspondant à une phase applicative et un cycle de test correspondant à une phase de test, ledit cycle de test comprenant un mode normal et un mode de sérialisation appelé également mode shift. Le circuit comporte en particulier des entrées, des bascules, des sélecteurs et des points d'interconnexions, qui lors du mode shift forment un ensemble de registres à décalage appelé chaîne de scan, ainsi qu'une logique combinatoire. En mode shift, des valeurs sérialisées d'entrée du vecteur de test peuvent être chargées à l'intérieur des bascules (couramment appelées dans la langue anglaise flip-flop) afin de tester ledit circuit, lesdites bascules étant commandées par une même horloge commune. Les valeurs sérialisées d'entrée se propagent à l'intérieur de la logique combinatoire. Après retour au mode normal, on récupère un résultat qui est comparé aux valeurs sérialisées de sortie du vecteur de test.

Les valeurs sérialisées d'entrée du vecteur peuvent être chargées en parallèle dans les bascules grâce à un simulateur suivi d'une étape de décalage desdites valeurs pour tester les bascules, comme le décrit le brevet US 5,574,853 déposé le 3 janvier 1994.

Bien que cet état de la technique permette de charger plus rapidement des valeurs d'entrée du vecteur de test et de tester le circuit sur le plan fonctionnel, il ne permet pas de tester le mode de sérialisation en lui-même, ni le fonctionnement des sélecteurs, ni le fonctionnement de l'horloge.

Aussi un problème technique à résoudre par l'objet de la présente invention est de proposer un procédé de test de circuit intégré destiné à fonctionner selon un mode normal et un mode de sérialisation, ledit circuit comprenant une horloge, des bascules simples et des sélecteurs associés, ledit procédé utilisant au moins un vecteur de test comportant des valeurs sérialisées d'entrée et de sortie, qui permette de valider efficacement le mode de sérialisation, les sélecteurs et l'horloge du circuit, tout en réduisant le temps pris par la simulation.

Une solution au problème technique posé se caractérise en ce que le procédé de test selon la présente invention comprend les étapes de :

- Positionner le circuit en mode de sérialisation au début d'un cycle d'horloge,
- Positionner en parallèle des valeurs sérialisées d'entrée du vecteur de test sur les sélecteurs,
- Charger en parallèle lesdites valeurs sérialisées d'entrée dans lesdites bascules simples associées audits sélecteurs,
- Positionner le circuit en mode normal,
- Capturer des valeurs sérialisées résultat dans les bascules,
- Récupérer en parallèle lesdites valeurs sérialisées résultat dans lesdites bascules et les comparer aux valeurs sérialisées de sortie du vecteur de test.

Selon un mode de réalisation non limitatif, le vecteur de test comporte en outre des valeurs fonctionnelles d'entrée et des valeurs fonctionnelles de sortie.

Selon un mode de réalisation non limitatif, le procédé de test de circuit intégré comporte en outre une étape d'application de valeurs fonctionnelles d'entrée du vecteur test sur le circuit, ladite étape étant effectuée préalablement au positionnement du circuit en mode normal.

Selon un mode de réalisation non limitatif, le procédé de test de circuit intégré comporte en outre une étape de récupération en parallèle des valeurs fonctionnelles résultat sur le circuit et de comparaison desdites valeurs avec des valeurs fonctionnelles de sortie du vecteur de test, ladite étape étant effectuée postérieurement au positionnement du circuit en mode normal.

Ainsi, comme on le verra en détail plus loin, un tel procédé permet, grâce à la première étape, de vérifier si une transition entre le mode normal et le mode de sérialisation se fait sans erreur. De plus, en positionnant des valeurs sur les sélecteurs et en appliquant des impulsions d'horloge, on contrôle également que lesdits sélecteurs ainsi que ladite horloge fonctionnent correctement.

La description qui suit, en regard des dessins annexés, le tout donné à titre d'exemples non limitatifs, fera bien comprendre en quoi consiste l'invention.

     - la Fig. 1 illustre de façon schématique une architecture d'un circuit intégré utilisé par le procédé selon l'invention,

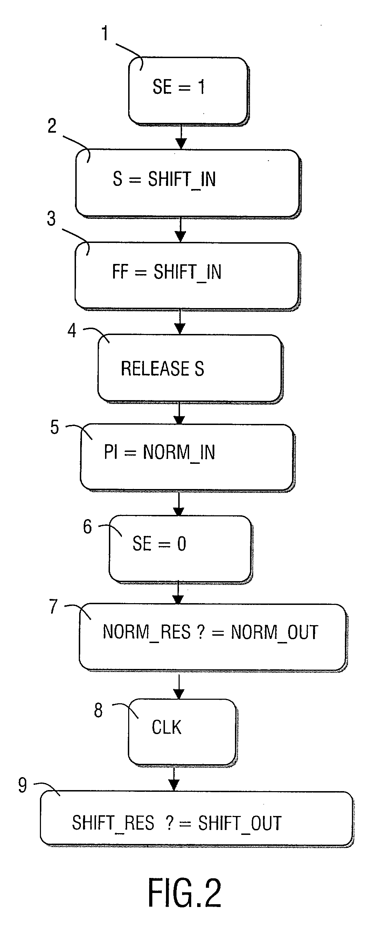

     - La Fig. 2 est un organigramme du procédé selon l'invention, et
     - La Fig. 3 est un diagramme de synchronisation de différents signaux générés ou utilisés par le procédé de la Fig. 2 lors d'une simulation.

Le présent exposé de l'invention a trait à un procédé de test de circuit intégré. Lors d'une fabrication d'un circuit intégré, il y a deux étapes principales à effectuer : une étape de conception du circuit notamment selon des fonctionnalités définies par un client, étape communément appelée étape de design, et une étape de fabrication. Afin de s'assurer que le circuit va bien pouvoir être testé physiquement lors de l'étape de fabrication par un testeur, on applique ledit procédé de test lors de l'étape de design sur un circuit intégré au moyen d'une simulation du circuit intégré par un simulateur SIMU. Le circuit intégré est modélisé et par simulation, on applique par simulation des vecteurs de test audit circuit modélisé comme on va le voir par la suite.

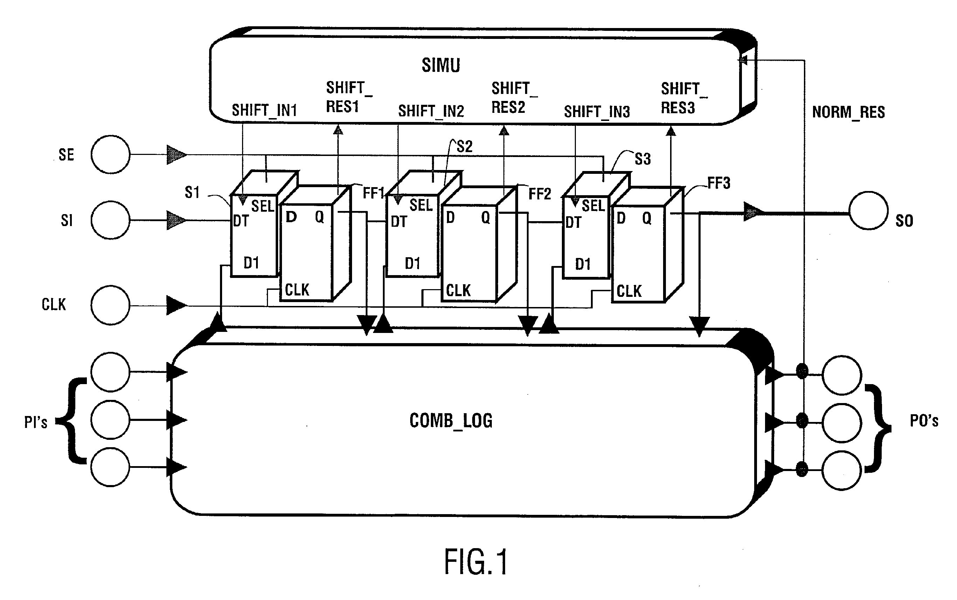

Le circuit intégré comporte un cycle fonctionnel et un cycle de test. Le circuit comporte des éléments de test ou chaîne de scan (appelés dans la langue anglaise « scan chain ») tels que des bascules, des sélecteurs et des broches d'entrée et de sortie. Le circuit intégré est de type tel qu'illustré à la figure 1. En cycle de test, le circuit intégré présente deux modes, un mode normal et un mode de sérialisation appelé mode shift où toutes les bascules, les sélecteurs sont interconnectés pour former un voire plusieurs registres à décalage ou chaîne de scan. Ledit circuit comporte en outre une logique combinatoire COM_LOG.

Dans l'exemple de la figure 1, les bascules de la chaîne de scan sont des bascules de scan MUX_FF comprenant des bascules simples FF, ici, trois bascules FF1, FF2 et FF3, et des sélecteurs S, ici trois sélecteurs S1, S2 et S3, un sélecteur S étant associé à chaque bascule simple FF. Le circuit comporte en outre une horloge CLK préférentiellement commune aux bascules MUX_FF, une broche de contrôle SE, une broche de test d'entrée SI, une broche de test de sortie SO, et des broches fonctionnelles d'entrée PI et de sortie PO. Les broches fonctionnelles d'entrée PI et de sortie PO sont connectées à la logique combinatoire COM_LOG.

La logique combinatoire COM_LOG ainsi que la chaîne de scan forment un ensemble qui réalise des fonctionnalités demandées par un client.

Les bascules simples FF sont préférentiellement de type D synchrones sensibles sur front montant et comportent une table de vérité qui est la suivante.

| CLK | D | Q | $\overline{Q}$ |
|---|---|---|---|
| ↑ | 0 | 0 | 1 |
| ↑ | 1 | 1 | 0 |
| 0 | X | $Q_{n-1}$ | $\overline{Q}_{n-1}$ |
| 1 | X | $Q_{n-1}$ | $\overline{Q}_{n-1}$ |

Sur la figure 1, est représentée uniquement la sortie Q qui nous intéresse.

L'entrée D est recopiée sur la sortie Q à chaque front montant de l'horloge CLK. Un sélecteur S qui est associé à chaque bascule FF précède ladite bascule et permet ainsi de sélectionner une entrée qui attaque la bascule FF associée. Ainsi, un sélecteur S comporte deux entrées DT et D1 permettant d'attaquer la bascule FF associée et une entrée de contrôle SEL permettant d'effectuer un choix entre les deux entrées DT ou D1 dudit sélecteur. Un sélecteur S comporte ainsi une table de vérité qui est la suivante.

| SEL | Sortie |
|---|---|
| 0 | D1 |
| 1 | DT |

Les entrées de contrôle SEL des sélecteurs S sont connectées à la broche de contrôle SE. La première entrée DT1 du premier sélecteur S1 est connectée à la broche de test SI.

Afin de vérifier que le design du circuit ne comporte pas d'erreur, on doit tester l'ensemble des éléments du circuit intégré cités précédemment. A cet effet, on utilise des vecteurs de test V. Un vecteur de test V comporte quatre ensemble de valeurs. Le premier ensemble contient des valeurs sérialisées d'entrée ou encore des valeurs de shift d'entrée SHIFT_IN qui sont appliquées en entrée dans les bascules de scan MUX_FF. Ces valeurs de shift d'entrée permettent de tester lesdites bascules de scan et permettent d'appliquer des stimuli d'entrée à la logique combinatoire COM_LOG du circuit, comme on le verra par la suite. Le deuxième ensemble contient des valeurs fonctionnelles d'entrée NORM_IN qui sont appliquées sur les entrées fonctionnelles PI du circuit. Le troisième ensemble contient des valeurs sérialisées de sortie ou encore des valeurs de shift de sortie SHIFT_OUT qui seront comparées avec des valeurs de shift résultat SHIFT_RES issues de la logique combinatoire COM_LOG. Le quatrième ensemble contient des valeurs fonctionnelles de sortie NORM_OUT qui permettent d'effectuer une comparaison avec des valeurs fonctionnelles résultat NORM_RES, comme on le verra par la suite.

Le test est effectué selon les étapes suivantes.

**Dans une 1ère étape MOD_SHIFT),** on positionne le circuit en mode shift au début d'un cycle d'horloge CLK. La broche de contrôle SE prend la valeur logique 1. Les bascules de scan MUX_FF sont alors interconnectées sous la forme d'un registre à décalage qui a pour entrée l'entrée DT1 du circuit, ladite entrée étant connectée à la broche d'entrée SI, et pour sortie la sortie Qn connectée sur la broche de sortie SO. Optionnellement, on peut rajouter un multiplexeur à la broche de sortie SO.

Contrairement à l'état de la technique antérieur présenté dans le préambule, cette première étape présente l'avantage de vérifier que la broche de contrôle SE est bien connectée et que la transition entre le mode normal et le mode shift s'effectue correctement.

Ainsi, par exemple, si la broche de contrôle SE est incorrectement connectée dans le circuit, elle a de grandes chances de passer à 0 et par suite la structure de registres à décalages s'en trouverait modifiée de sorte qu'on obtiendrait de mauvaises valeurs de sortie à la sortie du circuit.

Dans l'état de la technique antérieur, comme on force des valeurs directement dans les bascules simples FF, même si la broche de contrôle SE est incorrectement connectée, on ne le voit pas.

Par conséquent, en faisant varier la valeur de la broche de contrôle SE, on vérifie l'impact de cette broche sur le design du circuit, contrairement aux tests de l'état de la technique antérieur où la valeur de la broche de contrôle ne varie pas i.e. où elle est toujours soit à 1 soit à 0.

**Dans une 2ème étape FORCE),** on positionne des valeurs de shift d'entrée SHIFT_IN d'un vecteur de test V sur les entrées DT des sélecteurs S des bascules de scan MUX_FF et ce de façon parallèle grâce au simulateur SIMU.

Cette étape a pour avantage de ne plus entrer des valeurs de shift d'entrée par décalage dans la chaîne de scan en donnant des impulsions d'horloge CLK jusqu'à ce que tous les bits desdites valeurs se trouvent à la bonne place. Par conséquent, on réalise un gain de temps considérable au niveau de la simulation, en moyenne d'un facteur variant de 100 à 1000. Ce facteur est à peu près égal au nombre de bascules de scan MUX_FF se trouvant dans la chaîne de scan, ledit nombre représentant une longueur de chaîne de scan.

**Dans une 3éme étape CHARGE),** on charge lesdites valeurs de shift d'entrée SHIFT_IN dans lesdites bascules simples FF, et ce de façon parallèle. A cet effet, on applique une première impulsion d'horloge CLK pour déclencher le chargement. L'entrée D de la première bascule simple FF1 contient la première valeur de shift d'entrée SHIFT_IN1 du vecteur test V. L'entrée D de la deuxième bascule FF2 contient la deuxième valeur de shift d'entrée SHIFT_IN 2 du vecteur test V, l'entrée D de la troisième bascule FF3 contient la troisième valeur de shift d'entrée SHIFT_IN3 du vecteur test V, et ainsi de suite. Toute la chaîne de scan est remplie en une seule impulsion d'horloge CLK.

Cette étape a pour avantage de tester l'horloge CLK. En effet, dans le cas où l'horloge CLK serait mal connectée, cela se verrait car les valeurs capturées par la suite dans les bascules de scan MUX_FF seraient mauvaises, et le résultat obtenu en sortie serait lui aussi mauvais.

De plus, cette étape combinée avec l'étape 2 permet de tester les sélecteurs S. En effet, dans le cas où un sélecteur S ne marcherait pas, l'erreur se verrait car la valeur de shift d'entrée SHIFT_IN propagée dans la bascule FF associée serait mauvaise, la valeur capturée dans la bascule de scan MUX_FF correspondante serait également mauvaise, ainsi que le résultat obtenu en sortie.

**Dans une 4ème étape RELEASE),** le simulateur relâche les valeurs forcées dans les entrées DT des sélecteurs S. Les sorties Q de chaque bascule simple FF se propagent dans la logique combinatoire COMB_LOG.

**Dans une 5ème étape ENTER_PI),** on applique des valeurs fonctionnelles d'entrée de test NORM_IN sur les broches d'entrée fonctionnelles PI du circuit.

**Dans une 6ème étape MOD_NORM),** on positionne le circuit en mode normal afin de capturer par la suite des valeurs fonctionnelles du mode normal courant dans les bascules de scan MUX_FF. A cet effet, la broche de contrôle SE prend la valeur logique 0.

Préférentiellement, les étapes 5 et 6 sont effectuées en même temps.

**Dans une 7ème étape CMP_PO),** on récupère des valeurs fonctionnelles résultat NORM_RES à la sortie des broches fonctionnelles de sortie PO du circuit, et ce de façon parallèle grâce au simulateur SIMU, et on les compare aux valeurs fonctionnelles de sortie NORM_OUT du vecteur de test V testé.

**Dans une 8ème étape CAPTURE),** on donne une impulsion d'horloge CLK afin de capturer les bonnes valeurs dans les bascules de scan MUX_FF. Ainsi les valeurs de shift résultat SHIFT_RES qui sont récupérées dans les entrées D1 des sélecteurs des bascules MUX_FF (les entrées D des bascules simples FF sont connectées aux entrées D1 des sélecteurs S associés) et par suite qui sont récupérées dans les entrées D des bascules de scan MUX_FF, se propagent sur les sorties respectives Q desdites bascules de scan MUX_FF.

On notera qu'on effectue avantageusement la 7ème étape COMP_PO avant la 8ème étape CAPTURE afin d'éviter aux bascules simples FF d'envoyer des signaux à la logique combinatoire COMB_LOG et de détruire les valeurs qui se trouvaient dans les broches fonctionnelles de sortie PO.

Ainsi, les étapes 5 à 8 permettent de vérifier le bon fonctionnement des bascules de scan MUX_FF, et aussi de la logique combinatoire par la comparaison de PO.

**Dans une 9ème étape CMP_SCAN),** on récupère les valeurs de shift résultat SHIFT_RES comprises dans les sorties Q des bascules de scan MUX_FF, et ce de façon parallèle grâce au simulateur SIMU, et on les compare avec les valeurs de shift de sortie SHIFT_OUT du vecteur de test V.

Cette étape permet de gagner du temps lors du test. En effet, il évite de sortir les valeurs de shift résultat ainsi obtenues dans les bascules simples FF par décalage en appliquant autant d'impulsions d'horloge CLK qu'il est nécessaire pour sortir l'ensemble desdites valeurs de shift résultat.

Préférentiellement, cette comparaison s'effectue lors d'un mode shift, i.e. après qu'on a repositionné le circuit en mode shift (SE = 1).

Préférentiellement, le procédé s'effectue selon l'ordre des étapes présentées ci-dessus.

Ainsi, l'ensemble des étapes du procédé selon l'invention a pour avantage de tester la logique combinatoire COMB_LOG du circuit et les éléments de la chaîne de scan tout en diminuant le temps nécessaire pour un tel test.

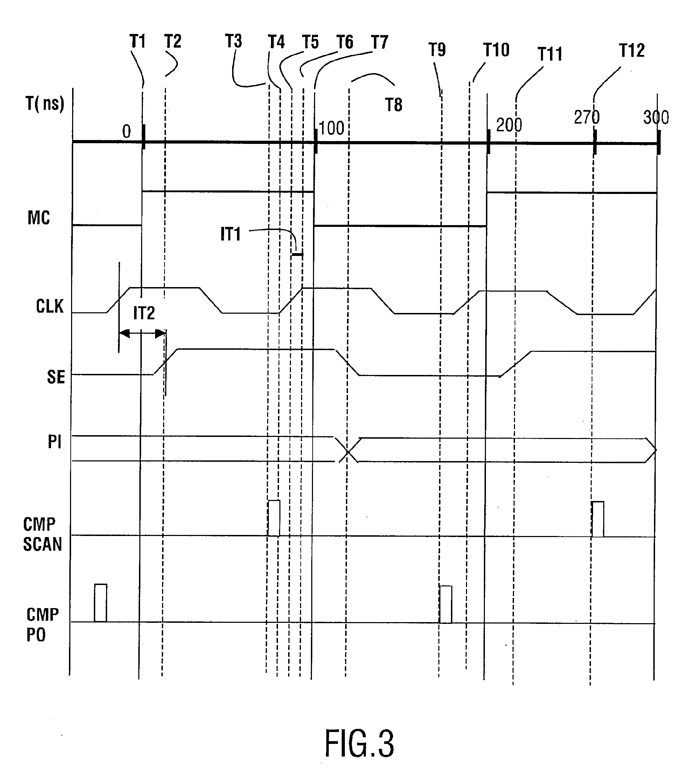

Préférentiellement, les étapes citées ci-dessus sont exécutées par le simulateur SIMU selon une synchronisation représentée à la figure 3. Cette synchronisation permet de tester les transitions du mode normal vers le mode shift sur 2 cycles d'horloge CLK uniquement pour chaque vecteur de test V testé.

Le testeur comporte une cadence MC. A titre d'information, elle est représentée à la figure 3. Au temps t1, le testeur entre dans un nouveau cycle de test.

Au temps t2, on effectue la 1$^{ère}$ étape MOD_SHIFT). On active le mode shift, la broche de contrôle SE est activée à 1.

Au temps t4, on effectue la 2$^{ème}$ étape FORCE). On force les valeurs de shift d'entrée SHIFT_IN d'un vecteur de test dans les entrées DT des sélecteurs S au moyen du simulateur SIMU. Préférentiellement, comme indiqué dans l'exemple de la figure 3, on force les dites valeurs avant le front montant de la prochaine impulsion d'horloge CLK, ceci afin de capturer les bonnes valeurs par la suite, celles qui ont été « forcées ».

Au temps t5, on effectue la 3$^{ème}$ étape CHARGE). On charge les valeurs de shift d'entrée SHIFT_IN dans les bascules simples FF par l'intermédiaire des sélecteurs S en donnant une impulsion d'horloge CLK.

Au temps t6, on effectue la 4$^{ème}$ étape RELEASE). On relâche les entrées DT des sélecteurs S. Cette étape est effectuée préférentiellement juste après le front montant de l'impulsion d'horloge CLK, ici, environ 1ns après l'étape de CHARGE, soit préalablement à l'étape ENTER_PI. Ainsi, on n'effectue pas le relâchement sur une transition d'un front montant d'horloge CLK. Il y a un premier intervalle de temps IT1 entre l'étape de chargement et plus précisément entre le front montant d'une impulsion d'horloge CLK déclenchant ladite étape et l'étape de relâchement. Ce premier intervalle de temps IT1 permet de relâcher les entrées une fois que les valeurs d'entrée de shift SHIFT_IN ont bien été propagées dans les bascules simples FF, soit sur les entrées D desdites bascules. On évite un problème communément appelé problème de « skew ». Sur les bascules simples FF, si on active l'horloge CLK et si en parallèle on modifie la valeur sur les entrées D desdites bascules en relâchant les entrées DT des sélecteurs S associés, on ne sait pas quelle valeur on a capturé dans lesdites bascules simples FF.

Ainsi, le premier intervalle de temps IT1 entre l'étape de relâchement et un front montant d'une impulsion d'horloge CLK est supérieur, ici il est de 1ns, au temps de d'établissement et de maintien d'une bascule (couramment appelé dans la langue anglaise « setup time & hold time »), bien connu de l'homme du métier. Ce temps d'établissement varie selon la technologie de la bascule. Dans l'état de la technique actuel, ce temps est de l'ordre de 0,1ns.

Au temps t7, le testeur commence un cycle fonctionnel.

Au temps t8, on active le mode normal, la broche de contrôle SE est resetée à 0, et dans le même temps, on applique aux broches d'entrée fonctionnelles PI, les valeurs de test fonctionnelles NORM_IN.

Au temps t9, on effectue l'étape de comparaison CMP_PO entre les valeurs fonctionnelles résultat NORM_RES obtenues et les valeurs fonctionnelles de sortie NORM_OUT du vecteur de test V.

Au temps t10, on redonne une impulsion d'horloge CLK pour capturer les valeurs de shift résultat SHIFT_RES selon l'étape CAPTURE, et au temps t11 on active de nouveau le mode shift (SE = 1).

Au temps t12, on effectue la 9$^{ème}$ étape COMP_SCAN. On compare les valeurs de shift résultat SHIFT_RES avec les valeurs de shift de sortie SHIFT_OUT du vecteur de test V.

On applique une nouvelle impulsion d'horloge CLK pour tester le vecteur de test V suivant, et ainsi de suite jusqu'à ce que l'ensemble des vecteurs de test V soient testés.

Un avantage supplémentaire du procédé de test selon l'invention se trouve dans le fait que pendant le même mode shift que celui de l'étape FORCE, on compare les valeurs de shift résultat SHIFT_RES obtenues lors d'un précédent mode shift avec les valeurs de shift de sortie SHIFT_OUT du vecteur de test V précédent dudit mode shift précédent, comme indiqué sur la figure 3, au temps t3 (étape CMP_SCAN).

Avantageusement, l'activation de la broche de contrôle SE (SE = 1) ne se fait pas en même temps que l'application d'une impulsion d'horloge CLK. Comme indiqué sur la figure 3, il existe également un deuxième intervalle de temps IT2 suffisant entre un front montant d'une impulsion d'horloge CLK et une transition d'un signal sur la broche de contrôle SE, i.e. ici le positionnement du circuit en mode shift. Préférentiellement, dans l'exemple proposé, ce deuxième intervalle de temps est préférentiellement pris supérieur ou égal à 10ns. Cela permet également d'éviter des problèmes de « skew » expliqué précédemment.

Ainsi, grâce au procédé de test par simulation, présenté ci-dessus, on anticipe des erreurs avant le vrai test physique du circuit par le testeur, ce qui permet de gagner un temps considérable lors de la fabrication de circuit intégré.

Dans le cas où une erreur surviendrait, on peut décider soit de continuer la simulation afin d'avoir une traçabilité de l'ensemble des erreurs, soit d'arrêter la simulation pour rechercher de suite la cause de l'erreur et la corriger.

On notera que, avant toutes ces étapes 1 à 9 décrites précédemment, on peut appliquer les tests suivants sur le circuit intégré.

- un test d'initialisation. Ce test permet d'appliquer un ensemble de stimuli au circuit qui se met alors en mode de scan i.e. le circuit est dans un certain état permettant de recevoir les vecteurs de test V;
- un test de continuité couramment appelé dans la langue anglaise « scan continuity test ». Ce test vérifie que la chaîne de scan du circuit n'est pas cassée. A cet effet, il maintient le signal SE à 1 et envoie un vecteur d'intégrité connu à la broche d'entrée SI. Ce vecteur doit se propager au travers de la chaîne de scan jusqu'à la broche de sortie SO après un nombre de cycles d'horloge CLK égal à une chaîne de scan la plus longue que l'on puisse trouver dans le circuit ;
- un test de N vecteurs de test en série. En général, on prend les 5 à 10 premiers vecteurs de test que l'on teste sur une chaîne de scan de façon sérielle, afin de vérifier que le programme de simulation de test s'exécute correctement.

Comme nous l'avons vu, les étapes du procédé de test décrit précédemment sont implémentées au moyen d'un simulateur SIMU. Un jeu d'instructions contenu dans une mémoire de programmation du simulateur peut engager le simulateur SIMU à effectuer les différentes étapes du procédé de test de circuit intégré précédemment décrit. Le jeu d'instructions peut aussi être chargé dans la mémoire de programmation par la lecture d'un support de données comme, par exemple un disque qui contient le jeu d'instructions. La lecture peut également s'effectuer par l'intermédiaire d'un réseau de communication comme, par exemple, le réseau internet. Dans ce cas, un fournisseur de service mettra le jeu d'instructions à la disposition des intéressés.

On notera que par la suite, on effectue les mêmes étapes sur le testeur pour tester physiquement le circuit intégré, mais en entrant des valeurs sur le circuit de façon sérielle et non plus en parallèle.

Bien entendu, le cadre de l'invention n'est nullement limité aux modes de réalisation décrits ci-dessus et des variations ou modifications peuvent y être apportés sans pour autant s'écarter de l'esprit et de la portée de l'invention.

Aucun signe de référence dans le présent texte ne doit être interprété comme limitant ledit texte.

Le verbe "comprendre" et ses conjugaisons ne doivent également pas être interprétés de façon limitative, i.e. ils ne doivent pas être interprétés comme excluant la présence d'autres étapes ou éléments outre ceux définis dans la description, ou encore, comme excluant une pluralité d'étapes ou d'éléments déjà listés après ledit verbe et précédés du mot "un" ou "une".

**Revendications**

1. Procédé de test de circuit intégré destiné à fonctionner selon un mode normal et un mode de sérialisation, ledit circuit comprenant une horloge (CLK), des bascules simples (FF) et des sélecteurs (S) associés, ledit procédé utilisant au moins un vecteur de test comportant des valeurs sérialisées d'entrée (SHIFT_IN) et de sortie (SHIFT_OUT), **caractérisé en ce qu'**il comporte les étapes de :

   - Positionner le circuit en mode de sérialisation au début d'un cycle d'horloge (CLK),
   - Positionner en parallèle des valeurs sérialisées d'entrée (SHIFT_IN) du vecteur de test (V) sur les sélecteurs (S),
   - Charger en parallèle lesdites valeurs sérialisées d'entrée (SHIFT_IN) dans lesdites bascules simples (FF) associées audits sélecteurs (S),
   - Positionner le circuit en mode normal,
   - Capturer des valeurs sérialisées résultat (SHIFT_RES) dans les bascules (FF),
   - Récupérer en parallèle lesdites valeurs sérialisées résultat (SHIFT_RES) dans lesdites bascules (FF) et les comparer aux valeurs sérialisées de sortie (SHIFT_OUT) du vecteur de test (V).

2. Procédé de test de circuit intégré selon la revendication 1, **caractérisé en ce qu'**il comporte en outre, une étape de relâchement des sélecteurs (S) effectuée juste après le chargement des valeurs sérialisées d'entrée (SHIFT_IN) dans les bascules simples (FF).

3. Procédé de test de circuit intégré selon la revendication 2, **caractérisé en ce qu'**il existe un premier intervalle de temps (IT1) entre l'étape de chargement en parallèle des valeurs sérialisées d'entrée (SHIFT_IN) et l'étape de relâchement des sélecteurs (S), ledit intervalle de temps (IT1) étant supérieur à un temps d'établissement et de maintien d'une bascule (FF).

4. Procédé de test de circuit intégré selon la revendication 3, **caractérisé en ce que** le premier intervalle de temps (IT1) existe entre un front montant d'une impulsion d'horloge (CLK) déclenchant l'étape de chargement et ladite étape de relâchement..

5. Procédé de test de circuit intégré selon la revendication 1, **caractérisé en ce qu'**il existe un deuxième intervalle de temps (IT2) entre un front montant d'une impulsion d'horloge (CLK) et le positionnement du circuit en mode de sérialisation.

6. Procédé de test de circuit intégré selon la revendication 1, **caractérisé en ce que** parallèlement au positionnement en parallèle des valeurs sérialisées d'entrée (SHIFT_IN) du vecteur de test (V) sur les sélecteurs (S), on compare les valeurs sérialisées résultat (SHIFT_RES) obtenues lors d'un précédent mode de sérialisation avec des valeurs sérialisées de sortie (SHIFT_OUT) d'un vecteur de test (V) précédent.

7. Procédé de test de circuit intégré selon la revendication 1, **caractérisé en ce que** le vecteur de test (V) comporte en outre des valeurs fonctionnelles d'entrée (NORM_IN) et des valeurs fonctionnelles de sortie (NORM_OUT).

8. Procédé de test de circuit intégré selon la revendication 7, **caractérisé en ce qu'**il comporte en outre une étape d'application de valeurs fonctionnelles d'entrée (NORM_IN) du vecteur test (V) sur le circuit, ladite étape étant effectuée préalablement au positionnement du circuit en mode normal.

9. Procédé de test de circuit intégré selon la revendication 8, **caractérisé en ce qu'**il comporte en outre une étape de récupération en parallèle de valeurs fonctionnelles résultat (NORM_RES) sur le circuit et de comparaison desdites valeurs avec des valeurs fonctionnelles de sortie (NORM_OUT) du vecteur de test (V), ladite étape étant effectuée postérieurement au positionnement du circuit en mode normal.

10. Procédé de test de circuit intégré selon la revendication 9, **caractérisé en ce que** l'étape de récupération des valeurs fonctionnelles résultat (NORM_RES) s'effectue avant l'étape de capture des valeurs sérialisées résultat (SHIFT_RES) se trouvant dans les bascules simples (FF).

FIG.1

FIG.2

FIG.3